# EUROPÄISCHE PATENTSCHRIFT

(11) **EP 2 989 870 B1**
(45) Veröffentlichungstag und Bekanntmachung des Hinweises auf die Patenterteilung: **27.03.2019**
(21) Anmeldenummer: 14721248.4
(22) Anmeldetag: 16.04.2014
(51) Int. Cl.: H05K 9/00

(54) **GEHÄUSE, SCHALTUNGSANORDNUNG, ANTRIEBSANORDNUNG SOWIE VERFAHREN ZUR HERSTELLUNG DER SCHALTUNGSANORDNUNG**
HOUSING, CIRCUIT ASSEMBLY, DRIVE ASSEMBLY AND METHOD FOR PRODUCING THE CIRCUIT ASSEMBLY
BOÎTIER, CIRCUIT, ENSEMBLE D'ENTRAÎNEMENT ET PROCÉDÉ PERMETTANT DE FABRIQUER LE CIRCUIT

(30) Priorität: 26.04.2013 DE 102013207673
(43) Veröffentlichungstag der Anmeldung: 02.03.2016
(73) Patentinhaber: Conti Temic microelectronic GmbH, 90411 Nürnberg (DE)
(72) Erfinder: NASSLER, Christian, 90461 Nürnberg (DE); VÖLKL, Thomas, 90455 Nürnberg (DE)
(74) Vertreter: Bonn, Roman Klemens
(86) Internationale Anmeldenummer: PCT/EP2014/057841
(87) Internationale Veröffentlichungsnummer: WO 2014/173790

(56) Entgegenhaltungen:
- WO-A1-2014/021035
- JP-A- 2001 044 685
- US-A- 4 717 990
- US-A1- 2013 021 771

## Beschreibung

Die vorliegende Erfindung betrifft ein Gehäuse für eine Schaltungsanordnung sowie eine Schaltungsanordnung mit dem genannten Gehäuse. Ferner betrifft die Erfindung eine Antriebsanordnung mit der genannten Schaltungsanordnung. Außerdem betrifft die Erfindung ein Verfahren zur Herstellung der genannten Schaltungsanordnung.

Die Druckschrift JP 2001 044685 A beschreibt ein Gehäuse für eine Schaltungsanordnung mit einem Gehäuseinnenraum und einer für elektromagnetischen Strahlung undurchlässigen Trennwand, welche den Gehäuseinnenraum räumlich in einen ersten und einen zweiten Teilbereich teilt. Die beiden Teilbereiche sind zur Aufnahme von elektrischen Bauelementen ausgebildet. Das Gehäuse umfasst ferner eine für elektromagnetische Strahlung undurchlässige Abdeckplatte und einen für elektromagnetische Strahlung undurchlässigen Gehäuseabschnitt, wobei die Trennwand, die Abdeckplatte und der Gehäuseabschnitt die beiden Teilbereiche des Gehäuses voneinander elektromagnetisch abschirmen.

Die Druckschrift US 2013/021771 A1 beschreibt einen Stromwandler, welcher eine Filterschaltung mit einem Reaktor und einem Kondensator umfasst, wobei der Reaktor einen Kern aufweist, der aus einer magnetischen Substanz besteht, welche um ein leitfähiges Verdrahtungselement herum angeordnet ist.

Die Druckschrift US 4 717 990 A beschreibt eine elektronische Vorrichtung, welche eine Gehäusewand aus einem elektrisch leitenden Material aufweist. Die Gehäusewand umfasst eine Außenwand und eine Trennwand, welche den Innenraum des Gehäuses in mehrere Teilbereiche aufteilt. Die Vorrichtung umfasst ferner eine elektronische Leiterplatte mit darauf montierten elektronischen Komponenten und Öffnungen, durch welche die Trennwände erstrecken.

Schaltungsanordnungen, insb. Stromrichter einer Antriebsanordnung eines Fahrzeugs, umfassen elektrische oder elektronische Bauelemente, die während des Betriebs der Schaltungsanordnungen elektromagnetische Störfelder erzeugen. Diese Schaltungsanordnungen umfassen ferner weitere elektrische oder elektronische Bauelemente, die auf elektromagnetische Störfelder empfindlich reagieren, weshalb diese zum Schutz vor diesen Störfeldern mit individuellen elektromagnetischen Abschirmungen versehen sind. Jedoch ist diese Herangehensweise aufwendig.
Damit besteht die Aufgabe der vorliegenden Erfindung darin, eine kostengünstige Möglichkeit zur elektromagnetischen Abschirmung der elektromagnetisch empfindlichen Bauelemente bereitzustellen.
Diese Aufgabe wird durch die unabhängigen Ansprüche gelöst. Vorteilhafte Ausgestaltungen sind Gegenstand der Unteransprüche.
Gemäß einem ersten Aspekt der Erfindung wird ein Gehäuse für eine Schaltungsanordnung bereitgestellt, das einen Gehäuseinnenraum sowie eine für elektromagnetische Strahlung undurchlässige Trennwand umfasst, die den Gehäuseinnenraum räumlich in einen ersten und einen zweiten Gehäuseinnenraumteilbereich teilt. Dabei ist der erste Gehäuseinnenraumteilbereich eingerichtet,
ein erstes, als ein Filterbauteil ausgebildetes, elektrisches
Bauelement aufzunehmen. Analog ist der zweite Gehäuseinnenraumteilbereich eingerichtet, ein zweites, elektrisches oder elektronisches Bauelement aufzunehmen. Das Gehäuse umfasst ferner eine für elektromagnetische Strahlung undurchlässige Abdeckplatte. Ferner umfasst das Gehäuse einen für elektromagnetische Strahlung undurchlässigen Gehäuseabschnitt. Dabei grenzt der Gehäuseabschnitt direkt an den ersten Gehäuseinnenraumteilbereich an. Insbesondere bildet der Gehäuseabschnitt zumindest eine Wand, die dem Gehäuseinnenraumteilbereich begrenzt. Im einem zusammengebauten Zustand des Gehäuses umschließen die Trennwand, die Abdeckplatte und der Gehäuseabschnitt den ersten Gehäuseinnenraumteilbereich derart dreidimensional (also räumlich), dass die Trennwand, die Abdeckplatte und der Gehäuseabschnitt eine vollständige elektromagnetische Abschirmung des ersten Gehäuseinnenraumteilbereichs gegenüber dem zweiten Gehäuseinnenraumteilbereich beziehungsweise gegenüber der Umgebung bilden.

Dabei sind unter dem Begriff "elektromagnetische Strahlung" insbesondere elektrische oder elektromagnetische Felder zu verstehen, wie sie beispielsweise als elektromagnetische Störfelder beim Betrieb von Strom- oder Spannungswandlern auftreten. Derartige Störfelder decken Frequenzen von bis 1GHz, vorzugsweise von 50KHz bis 300MHz, insbesondere von 150KHz bis 50MHz, ab.

Die Wortgruppe "für elektromagnetische Strahlung undurchlässig" bedeutet in dieser Anmeldung, dass elektromagnetische Störfelder, die Funktionsstörungen in den elektrischen oder elektronischen Bauelementen, insb. in den Filterbauelementen eines EMV(Elektromagnetische Verträglichkeit)-Filters, auslösen können, von der Trennwand, der Abdeckplatte sowie dem Gehäuseabschnitt entsprechend absorbiert beziehungsweise gedämpft werden, so dass diese zu den jeweiligen Bauelementen nicht beziehungsweise nicht in der Intensität erreichen, die Funktionsstörungen in den jeweiligen Bauelementen auslösen kann. Die Absorption beziehungsweise Dämpfung dieser Störfelder beträgt zum Beispiel bei einem Frequenzbereich der Störfelder zwischen 10KHz, oder 1MHz bis 30MHz mindestens 40dB, vorzugsweise mindestens 50dB, oder 60dB, insbesondere 80dB.

Die Wortgruppe "den ersten Gehäuseinnenraumteilbereich dreidimensional umschließen" bedeutet in dieser Anmeldung, dass der genannte Gehäuseinnenraumteilbereich von umhüllenden beziehungsweise umschließenden Teilen nur bis auf zwei oder mehr Öffnungen, die zum Hindurchführen von zur Funktionalität des ersten Bauelements notwendigen elektrischen Verbindungen in diesen Gehäuseinnenraumteilbereich unbedingt erforderlich sind, dreidimensional vollständig umschlossen beziehungsweise umhüllt wird. Diese Umschließung resultiert in der Abschirmung, die insbesondere in technischer Sicht als vollständig betrachtet werden kann. Hierbei bezieht sich der Begriff "vollständig" insbesondere auf die Funktion der Abschirmung nämlich der Unterdrückung von Funktionsstörungen durch elektromagnetische Störfelder innerhalb der Abschirmung, die außerhalb der Abschirmung erzeugt werden.

Dabei sind die Öffnungen an Stellen der umhüllenden beziehungsweise umschließenden Teile angeordnet, welche bezogen auf die Teile von Quellen der oben genannten elektromagnetischen Störfelder abgewandt liegen. Dadurch werden die elektromagnetischen Störfelder von den umhüllenden beziehungsweise umschließenden Teilen weitgehend absorbiert beziehungsweise gedämpft, bevor diese zu den Öffnungen zu gelangen.

Die Wortgruppe "eine vollständige elektromagnetische Abschirmung" bedeutet eine Abschirmung von den elektrischen oder elektronischen Bauelementen vor den elektrischen oder elektromagnetischen Störfeldern, wobei die Störfelder von den umhüllenden beziehungsweise umschließenden Teilen vollständig beziehungsweise nahezu vollständig absorbiert beziehungsweise gedämpft werden. Dadurch gelangen die elektromagnetischen Störfelder nicht zu den genannten Bauelementen beziehungsweise nicht in der Intensität, die Funktionsstörungen bei den Bauelementen auslösen kann. Die "vollständige" Abschirmung wird insbesondere bei einem Frequenzbereich der Störfelder zwischen 10KHz, oder 1MHz bis 30MHz erzielt.

Der Gehäuseabschnitt ist ein Teil des Gehäuses, umfasst vorzugsweise einen Teil einer Gehäuseseitenwand des Gehäuses und/oder einen Teil eines Gehäusebodens des Gehäuses und grenzt den ersten Gehäuseinnenraumteilbereich von dem zweiten Gehäuseinnenraumteilbereich und von der Gehäuseumgebung räumlich ab. Der Gehäuseabschnitt wird somit durch Wandabschnitt des Gehäuses gebildet. Vorzugsweise ist der Gehäuseabschnitt flächig.

Der Erfindung liegt die Überlegung zugrunde, dass eine elektromagentische Abschirmung der ersten, gegenüber den elektromagnetischen Störfeldern empfindlich reagierenden Bauelemente einer Schaltungsanordnung von den zweiten Bauelementen der Schaltungsanordnung, die elektromagnetische Störfelder erzeugen, erzielt werden kann, wenn die elektromagnetischen Feldflüsse von den zweiten Bauelementen zu den ersten Bauelementen gedämpft beziehungsweise geschwächt werden.

Dabei ist es denkbar, diese ersten Bauelemente mit elektromagnetisch abschirmenden Gehäusen zu versehen. Umgekehrt können die zweiten Bauelemente, die elektromagnetische Störfelder erzeugen, mit entsprechenden elektromagnetisch abschirmenden Gehäusen versehen werden.

Die ersten und/oder die zweiten Bauelemente mit entsprechenden elektromagnetisch abschirmenden Gehäusen auszustatten, wäre aber kostspielig und würde zudem den gesamten Umfang der Bauelemente übermäßig vergrößern, was wiederum einen größeren Bauraum in der Schaltungsanordnung beanspruchen würde.

Um eine kostengünstige und bauraumsparende Lösung einer zumindest gleich effektiven elektromagnetischen Abschirmung zwischen den ersten und den zweiten Bauelementen zu erzielen, wurde im Rahmen dieser Erfindung erkannt, den Gehäuseinnenraum, der sowohl die ersten als auch die zweiten Bauelemente aufnimmt, in zumindest zwei Gehäuseinnenraumteilbereiche aufzuteilen, und die ersten und die zweiten Bauelemente getrennt in diesen beiden Gehäuseinnenraumteilbereichen anzuordnen.

Es wurde ferner erkannt, dass eine wirksame elektromagnetische Abschirmung des ersten Gehäuseinnenraumteilbereichs von dem zweiten Gehäuseinnenraumteilbereich durch eine den ersten Gehäuseinnenraumteilbereich räumlich dreidimensional und in technischer Sicht vollständig umschließende und elektromagnetisch abschirmende Umhüllung erzielt werden kann, die elektromagnetische Strahlungen vollständig beziehungsweise nahezu vollständig dämpft und somit nicht, beziehungsweise nicht in der Intensität in den einen Gehäuseinnenraumteilbereich durchlässt, die Funktionsstörungen in den in diesem Bereich befindlichen, ersten Bauelementen auslösen können.

Durch die Aufteilung des Gehäuseinnenraumes in mindestens zwei Gehäuseinnenraumteilbereichen und durch die elektromagnetische Abschirmung zwischen diesen beiden Gehäuseinnenraumteilbereichen mithilfe der elektromagnetisch abschirmende Umhüllung können die ersten, elektromagnetisch empfindlichen Bauelemente und die zweiten Bauelemente, die elektromagnetische Störfelder erzeugen, voneinander getrennt in den beiden voneinander elektromagnetisch abgeschirmten Gehäuseinnenraumteilbereichen angeordnet werden. Dabei können auf eigene, individuelle Gehäuse bei den Bauelementen verzichtet werden, die die ersten Bauelemente vor den elektromagnetischen Störfeldern schützen oder verhindern sollen, dass die in den zweiten Bauelementen erzeugten, elektromagnetischen Störfelder nach außen zu gelangen. Derartige gehäuselose Bauelemente beanspruchen einen vergleichsweise wesentlich geringen Bauraum in dem Gehäuse der Schaltungsanordnung. Dadurch kann das Gehäuse der Schaltungsanordnung kleiner dimensioniert werden.

Dabei wird die räumliche Trennung der beiden Gehäuseinnenraumteilbereiche in erster Linie mittels einer Trennwand einfach realisiert, die den Gehäuseinnenraum in die zwei Gehäuseinnenraumteilbereiche unterteilt und die elektromagnetischen Strahlungen von den zweiten Bauelementen dämpft. Durch diese räumliche Trennung ist somit auch eine Möglichkeit gegeben, die elektromagnetische Abschirmung zu realisieren.

Um den Bauraum weiter zu reduzieren, wird zudem ein Teil des Gehäuses, nämlich ein Gehäuseabschnitt zur räumlichen Trennung sowie zur Bildung der elektromagnetisch abschirmenden Umhüllung zwischen den beiden Gehäuseinnenraumteilbereichen einbezogen. Dabei ist der Gehäuseabschnitt derart ausgebildet, dass dieser ebenfalls die elektromagnetischen Strahlungen von den zweiten Bauelementen dämpft und somit nicht, beziehungsweise nicht in der Intensität durchlässt, die Funktionsstörungen in den ersten Bauelementen auslösen können.

Um den ersten Gehäuseinnenraumteilbereich von dem zweiten Gehäuseinnenraumteilbereich weitgehend vollständig zu trennen und elektromagnetisch abzuschirmen, wird eine Abdeckplatte hinzugezogen, die mit der Trennwand und dem Gehäuseabschnitt den ersten Gehäuseinnenraumteilbereich dreidimensional und vollständig umhüllt und somit eine weitgehend vollständige elektromagnetische Abschirmung des ersten Gehäuseinnenraumteilbereichs von dem zweiten Gehäuseinnenraumteilbereich ermöglicht. Dabei ist die Abdeckplatte ebenfalls derart ausgebildet, dass dieser die elektromagnetischen Strahlungen von den zweiten Bauelementen dämpft. Dabei können die Trennwand und die Abdeckplatte als dünne Platten ausgebildet sein, die einen vernachlässigbar geringen Bauraum beanspruchen, der durch die Einsparung bei den sonst erforderlichen Gehäusen der Bauelemente nicht ins Gewicht fällt.

Da die elektromagnetische Abschirmung zum Teil mittels des Gehäuseabschnitts realisiert wird, der als Teil des Gehäuses keinen zusätzlichen Bauraum beansprucht, wird der Bauraum im Gehäuse weiter reduziert. Da die Trennwand und die Abdeckplatte im Vergleich zu den individuellen Gehäusen der Bauelemente einfacher und kostengünstiger herstellbar sind, kann die Schaltungsanordnung insgesamt günstiger hergestellt werden.

Dadurch ist ein Gehäuse für eine Schaltungsanordnung geschaffen, mit dem eine kostengünstige, bauraumsparende und wirksame elektromagnetische Abschirmung der elektromagnetisch empfindlichen Bauelemente der Schaltungsanordnung ermöglicht ist.

Gemäß einer bevorzugten Ausgestaltung sind die Abdeckplatte, die Trennwand und der Gehäuseabschnitt miteinander elektrisch leitend und mechanisch verbunden. Dies stellt eine stoß- und schütterungsfeste Verbindung zwischen der Abdeckplatte und dem Gehäuse und eine zuverlässige elektrische Abschirmung sicher.

Hierbei bedeutet eine "elektrisch leitende mechanische Verbindung" eine mechanische feste Verbindung zweier Teile, die zugleich eine niederohmige elektrische Verbindung dieser beiden Teile herstellt, wobei durch diese Verbindung beim Anlegen einer Spannung zwischen diesen beiden verbundenen Teilen der Spannungsunterschied zwischen den Teilen auf einen Wert nahe null fallen würde. Dabei ist die elektrisch leitende und mechanische Verbindung über einen direkten körperlichen Kontakt der beiden verbundenen Teile ausgebildet. Eine derartige Verbindung ist beispielsweise über eine stoffschlüssige Verbindung, wie zum Beispiel eine Lötverbindung, eine elektrisch leitende Klebe- oder Schweißverbindung, oder über eine formschlüssige Verbindung mittels elektrisch leitenden Schrauben oder Nieten herstellbar.

Gemäß einer weiteren bevorzugten Ausgestaltung sind die Abdeckplatte, die Trennwand und/oder der Gehäuseabschnitt eingerichtet, mit einem Stromanschluss, insb. einem Masseanschluss, des ersten Bauelements elektrisch leitend verbunden zu werden. Hierzu sind die Abdeckplatte, die Trennwand und/oder der Gehäuseabschnitt mit zumindest einem entsprechenden elektrischen Anschluss ausgebildet.

Hierbei bedeutet eine "elektrische Verbindung" eine niederohmige elektrische Verbindung zweier Teile, wobei durch diese Verbindung beim Anlegen einer Spannung zwischen diesen beiden Teilen der Spannungsunterschied zwischen den Teilen auf einen Wert nahe null fallen würde.

Diese Ausgestaltung bietet den Vorteil, dass die Abdeckplatte, die Trennwand und/oder der Gehäuseabschnitt neben der elektromagnetischen Abschirmung noch als elektrische Verbindung von dem Stromanschluss des Bauelements mit einer externen Schaltungseinheit, beispielsweise zwischen dem Masseanschluss des Bauelements und einer externen Masse, dienen können. Damit erfüllen die Abdeckplatte, die Trennwand und/oder der Gehäuseabschnitt zwei Funktionen gleichzeitig und dadurch entfällt zusätzliche elektrische Leitung, die sonst für eine elektrische Verbindung von dem Stromanschluss des Bauelements zu der externen Schaltungseinheit erforderlich wäre.

Gemäß einer weiteren bevorzugten Ausgestaltung ist die Abdeckplatte eingerichtet, über den genannten Stromanschluss direkt mit dem ersten Bauelement elektrisch leitend und mechanisch verbunden zu werden. Hierzu weist die Abdeckplatte zumindest einen elektrischen Anschluss auf, der mit dem genannten Stromanschluss des ersten Bauelements sowohl elektrisch als auch mechanisch verbindbar ausgebildet ist.

Diese Ausgestaltung bietet den Vorteil, dass die Abdeckplatte zugleich auch als Träger des ersten Bauelements dienen kann. Dadurch entfällt ein zusätzlicher Schaltungsträger zur mechanischen Befestigung des ersten Bauelements und zur Herstellung elektrischer Verbindung dieses Bauelements zu der externen Schaltungseinheit.

Gemäß noch einer weiteren bevorzugten Ausgestaltung umfassen die Trennwand, die Abdeckplatte und/oder der Gehäuseabschnitt elektrisch leitendes und/oder weichmagnetisches Material. Vorzugsweise sind die Trennwand, die Abdeckplatte und/oder der Gehäuseabschnitt aus einem gleichen elektrisch leitenden und/oder weichmagnetischen Material ausgebildet.

Die zuletzt genannten Ausgestaltungen stellen eine wirksame elektromagnetische Abschirmung des ersten Bauelements sicher. Durch Verwendung eines und desselben elektrisch leitenden und/oder weichmagnetischen Materials werden die Herstellungskosten weiter gesenkt.

Gemäß noch einer weiteren bevorzugten Ausgestaltung sind die Trennwand und der Gehäuseabschnitt einstückig ausgebildet. Vorzugsweise ist das gesamte Gehäuse mit der Trennwand einstückig ausgebildet. Dabei kann das Gehäuse in einem Gießvorgang, wie zum Beispiel Spritzgießen, hergestellt werden, wobei in dem Gießvorgang des Gehäuses die Trennwand an dem Gehäuseabschnitt mit diesem Gehäuseabschnitt beziehungsweise dem Gehäuse einstückig geformt wird. Dadurch lässt sich das Gehäuse beziehungsweise der Gehäuseabschnitt samt der Trennwand als Massenware kostengünstig herstellen.

Gemäß noch einer weiteren bevorzugten Ausgestaltung umhüllt, umgibt beziehungsweise umschließt die Trennwand den ersten Gehäuseinnenraumteilbereich vollständig. Dadurch bildet die Trennwand eine mantelförmige Hülle um den ersten Gehäuseinnenraum herum, in dem das erste Bauelement angeordnet werden kann.

Gemäß einem zweiten Aspekt der Erfindung wird eine Schaltungsanordnung bereitgestellt, die das oben bereits beschriebene Gehäuse, das erste, als ein Filterbauelement ausgebildete elektrische Bauelement sowie das zweite elektrische oder elektronische Bauelement umfasst. Dabei sind das erste Bauelement in dem ersten Gehäuseinnenraumteilbereich des Gehäuses und das zweite Bauelement in dem zweiten Gehäuseinnenraumteilbereich des Gehäuses angeordnet.

Insbesondere kann die Schaltungsanordnung als ein Strom-/Spannungswandler oder ein Stromrichter zum Umwandeln elektrischen Stromes von einer Stromart in eine andere Stromart, insbesondere als ein Wechselrichter oder ein Gleichrichter, ausgebildet sein. Das erste als ein Filterbauelement ausgebildete elektrische Bauelement kann dabei ein EMV-Filter beziehungsweise ein Teil des EMV-Filters sein.

In einer bevorzugten Ausgestaltung der Schaltungsanordnung umfasst das erste Bauelement den Stromanschluss zur Herstellung einer elektrisch leitenden Verbindung mit einem elektrischen Massepotenzial, und ist über diesen Stromanschluss mit der Abdeckplatte direkt elektrisch leitend und mechanisch verbunden.

Hierbei bedeutet eine "direkt elektrisch leitende und mechanische Verbindung" eine körperlich aneinander stoßende elektrische und mechanische Verbindung, die gegebenenfalls eine elektrisch leitende Schicht zwischen den beiden verbundenen Teilen enthält, die beispielsweise als eine Löt-, Klebe- oder Schweißverbindungsschicht ausgebildet ist und die beiden Teile miteinander elektrisch und mechanisch verbindet.

Gemäß noch einer weiteren bevorzugten Ausgestaltung der Schaltungsanordnung ist das erste Bauelement an der Abdeckplatte über eine mechanische Verbindung befestigt, wobei diese mechanische Verbindung zugleich die oben genannte elektrische Verbindung herstellt, die den Stromanschluss des ersten Bauelements mit der Abdeckplatte direkt elektrisch leitend verbindet.

Gemäß noch einer weiteren bevorzugten Ausgestaltung ist das erste Bauelement als ein Kondensator oder als eine Spule ausgebildet. Dabei ist der Kondensator oder die Spule beispielsweise ein Teil eines EMV-Filters.

Gemäß einem dritten Aspekt der Erfindung wird eine Antriebsanordnung für ein Fahrzeug bereitgestellt, die eine elektrische Maschine zum Antrieb des Fahrzeugs sowie eine oben beschriebene Schaltungsanordnung aufweist. Dabei ist die Schaltungsanordnung über eine elektrische Verbindung mit der elektrischen Maschine elektrisch verbunden und stellt der elektrischen Maschine elektrische Energie in Form von Rotor- oder Statorströmen bereit.

Gemäß einem vierten Aspekt der Erfindung wird ein Verfahren zur Herstellung einer oben beschriebenen Schaltungsanordnung bereitgestellt, das folgende Verfahrensschritte aufweist. Es wird eine elektrisch leitende mechanische Verbindung zwischen dem ersten elektrischen Bauelement und der Abdeckplatte hergestellt. Nachdem die elektrisch leitende mechanische Verbindung zwischen dem ersten Bauelement und der Abdeckplatte hergestellt wurde, wird die Abdeckplatte samt dem Bauelement an der Trennwand und/oder dem Gehäuseabschnitt des Gehäuses befestigt.

Vorteilhafte Ausgestaltungen des oben beschriebenen Gehäuses sind, soweit im Übrigen auf die oben genannte Schaltungsanordnung, Antriebsanordnung beziehungsweise das oben genannte Verfahren übertragbar, auch als vorteilhafte Ausgestaltungen der Schaltungsanordnung, der Antriebsanordnung beziehungsweise des Verfahrens anzusehen.

Im Folgenden sollen nun beispielhafte Ausführungsformen der vorliegenden Erfindung bezugnehmend auf die beiliegenden Zeichnungen näher erläutert werden. Dabei zeigen:
- Figur 1: eine schematische Darstellung eines Fahrzeugs mit einer Antriebsanordnung aufweisend einer Schaltungsanordnung gemäß einer Ausführungsform der Erfindung;
- Figur 2: eine schematische Explosionsdarstellung der Schaltungsanordnung der Ausführungsform der Erfindung;
- Figur 3: in einem schematischen Diagramm das Verfahren zur Herstellung der Schaltungsanordnung der Ausführungsformen der Erfindung.

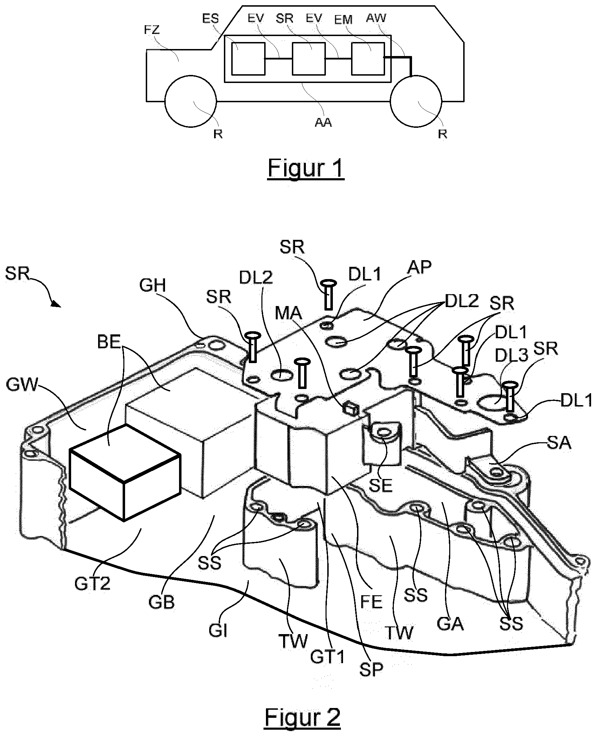

Es sei zunächst auf Figur 1 verwiesen, in der ein Fahrzeug FZ mit Rädern R und einer Antriebsanordnung AA zum Antreiben der Räder R schematisch dargestellt ist.

Die Antriebsanordnung AA umfasst eine Antriebswelle AW, eine elektrische Maschine EM, eine als ein Stromrichter SR ausgebildete Schaltungsanordnung sowie einen elektrischen Energiespeicher ES.

Die Antriebswelle AW verbindet die elektrische Maschine EM mit den Rädern R und überträgt die von der elektrischen Maschine EM erzeugte mechanische Energie an die Räder R zu deren Antrieb. Die elektrische Maschine EM ist über eine elektrische Verbindung EV mit dem Stromrichter SR verbunden. Der Stromrichter SR ist wiederum über eine weitere elektrische Verbindung EV mit dem Energiespeicher ES verbunden, der elektrische Energie für die elektrische Maschine EM zu deren Betrieb bereitstellt. Die von dem Energiespeicher ES in Form von Gleichstrom bereitgestellte elektrische Energie wird von dem Stromrichter SR in einer dem Fachmann bekannten Weise in Phasenströmen zum Betreiben der elektrischen Maschine EM umgewandelt und der elektrischen Maschine EM bereitgestellt. Die elektrische Maschine EM wandelt die elektrische Energie in mechanische Energie um und treibt über die Antriebswelle AW die Räder R und somit das Fahrzeug FZ an.

Der mechanische Aufbau des Stromrichters SR ist in Figur 2 in einer schematischen Explosionsdarstellung teils in Abschnitt schematisch gezeigt.

Dabei weist der Stromrichter SR ein Gehäuse GH und einen in Figur nicht dargestellten Gehäusedeckel auf. Das Gehäuse GH umfasst eine Gehäuseseitenwand GW und einen Gehäuseboden GB, und weist einen wannenförmigen Gehäuseinnenraum GI zur Aufnahme von elektrischen und elektronischen Komponenten des Stromrichter SR auf.

Der Stromrichter SR umfasst ferner als elektrische und elektronische Komponenten einen EMV-Filter mit einem Filterbauelement FE, das in dieser Ausführungsform eine Gruppe von Kondensatoren umfasst, sowie eine Brückenschaltung mit weiteren elektrischen und elektronischen Bauelementen BE, wie zum Beispiel Schalttransistoren.

Das Filterbauelement FE beziehungsweise der EMV-Filter unterdrückt während des Betriebs des Stromrichters SR unerwünschte störende Spannungssignalanteile in dem vom Energiespeicher ES bereitgestellten Gleichstrom und trägt somit der elektromagnetischen Verträglichkeit des Stromrichters SR bei. Hierzu weist das Filterbauelement FE einen Stromeingangsanschluss SE zur Aufnahme vom mit störenden Spannungssignalanteilen überlagerten Gleichstrom und einen Stromausganganschluss SA zur Abgabe vom gefilterten Gleichstrom sowie mehrere Massestromanschlüsse MA zur elektrischen Masseverbindung auf.

Die weiteren elektrischen und elektronischen Bauelemente BE wie die Schalttransistoren im Stromrichter SR erzeugen während des Betriebs des Stromrichters SR elektrische oder elektromagnetische Störfelder, die bei dem Filterbauelement FE Funktionsstörungen und sogar zum Ausfall des Filterbauelements FE führen können.

Um das Filterbauelement FE vor den elektrischen oder elektromagnetischen Störfeldern der umliegenden Bauelemente BE des Stromrichters SR zu schützen, ist der Stromrichter SR mit einer Abdeckplatte AP aus elektrisch leitendem und weichmagnetischem Material versehen. Ferner ist das Gehäuse GH aus elektrisch leitendem und weichmagnetischem Material ausgebildet und mit einer rippenförmig geformten Trennwand TW versehen, die mit dem Gehäuse GH einstückig und als Erweiterung der Gehäuseseitenwand GW des Gehäuses GH in den Gehäuseinnenraum GI hinein erstreckend ausgebildet ist und somit ebenfalls aus dem elektrisch leitenden und weichmagnetischen Material besteht.

Diese Trennwand TW teilt dabei den Gehäuseinnenraum GI in einen ersten Gehäuseinnenraumteilbereich GT1 und einen zweiten Gehäuseinnenraumteilbereich GT2 und grenzt mit einem Gehäuseabschnitt GA den ersten Gehäuseinnenraumteilbereich GT1 von dem zweiten Gehäuseinnenraumteilbereich GT2 räumlich ab. Dabei umfasst der Gehäuseabschnitt GA einen Teil der Gehäuseseitenwand GW und einen Teil des Gehäusebodens GB.

In einem zusammengebauten Zustand ist das Filterbauelement FE in dem ersten Gehäuseinnenraumteilbereich GT1 und von den weiteren elektrischen oder elektronischen Bauelementen BE räumlich getrennt angeordnet, die in dem zweiten Gehäuseinnenraumteilbereich GT2 angeordnet sind.

In diesem zusammengebauten Zustand ist die Abdeckplatte AP auf der Trennwand TW und dem Gehäuseabschnitt GA angeordnet und mittels elektrisch leitenden Schrauben SR an der Trennwand TW beziehungsweise dem Gehäuseabschnitt GA befestigt und somit mit der Trennwand TW beziehungsweise dem Gehäuseabschnitt GA elektrisch leitend verbunden. Dabei umschließen die Abdeckplatte AP, die Trennwand TW und der Gehäuseabschnitt GA den ersten Gehäuseinnenraumteilbereich GT1 derart, dass elektrische beziehungsweise elektromagnetische Störfelder, die von den im zweiten Gehäuseinnenraumteilbereich GT2 angeordneten Bauelementen BE erzeugt werden, von der Abdeckplatte AP, der Trennwand TW und dem Gehäuseabschnitt GA gedämpft werden und somit nicht, beziehungsweise nicht in einer Intensität in den ersten Gehäuseinnenraumteilbereich GT1 hineindringen und beim Filterbauelement FE Störungen oder gar Schäden auslösen können.

Zur Befestigung an der Trennwand TW beziehungsweise an dem Gehäuseabschnitt GA weist die Abdeckplatte AP an entsprechenden Stellen am Rand der Abdeckplatte AP eine Gruppe von ersten Durchgangslöchern DL1 auf. Entsprechend sind die Trennwand TW und der Gehäuseabschnitt GW an entsprechenden Stellen mit entsprechenden Schraubenschächten SS zur Aufnahme und zum Halten von Schrauben SR versehen. Zur Befestigung der Abdeckplatte AP an der Trennwand TW und dem Gehäuseabschnitt GW werden die Schrauben SR durch die ersten Durchgangslöcher DL1 hindurchgeführt und in die jeweiligen Schraubenschächte SS eingeschraubt. Dabei wird die Schraubenverbindung zwischen der Abdeckplatte AP und der Trennwand TW beziehungsweise dem Gehäuseabschnitt GW mit einer ausreichen hohen Anzahl von Schrauben SR mit kleinen Abständen zueinander hergestellt. Der Abstand zwischen den Schrauben ist beispielsweise kleiner als 20-, 15-, 10-, 8- oder 5-fache des Durchmessers der verwendeten Schrauben SR. Insbesondere werden die Schrauben SR in dem Bereich, wo eine Stromverbindung zu dem Stromausgangsanschluss SA zum Weiterleiten des gefilterten störsignalfreien Gleichstromes geführt wird, in vergleichsweise noch kleineren Abständen verschraubt. Dadurch wird eine niederohmige elektrische Verbindung von der Abdeckplatte AP zu der Trennwand TW und dem Gehäuseabschnitt GW erzielt.

Das Filterbauelement FE ist im zusammengebauten Zustand des Stromrichters SR an der Abdeckplatte AP befestigt, wobei das Filterbauelement FE über Lötverbindungen zwischen Massestromanschlüssen MA des Filterbauelements FE und dafür vorgesehenen Verbindungsstellen an der Abdeckplatte AP mit der Abdeckplatte AP elektrisch leitend und mechanisch verbunden ist. Dabei sind die Verbindungsstellen an der Abdeckplatte AP in Form von zweiten Durchgangslöchern DL2 ausgebildet. Durch diese zweiten Durchgangslöcher DL2 ragen die stiftförmig ausgebildeten Masseanschlüsse MA des Filterbauelements FE hindurch und sind mit der Abdeckplatte AP mittels Lötverbindungen mechanisch und elektrisch leitend verbunden. Über die Abdeckplatte AP, die elektrisch leitende Trennwand TW sowie den elektrisch leitenden Gehäuseabschnitt GW sind die Masseanschlüsse MA ferner mit der elektrischen Masse verbunden.

Damit dient die Abdeckplatte AP als Schaltungsträger für das Filterbauelement FE zur mechanischen Befestigung des Filterbauelements FE und zur Herstellung von elektrischen Verbindungen von den Masseanschlüssen MA des Filterbauelements FE zur elektrischen Masse. Die Abdeckplatte AP, die Trennwand TW und der Gehäuseabschnitt GW stellen somit eine flächig ausgeführte elektrische Verbindung von dem Filterbauelement FE zur elektrischen Masse her.

Der Umfang der zweiten Durchgangslöcher DL2 ist zudem größer als der des Querschnitts der Masseanschlüsse MA ausgeführt, sodass die Fertigungstoleranzen zwischen dem Filterbauelement FE und der Abdeckplatte AP ausgeglichen werden können.

Die Trennwand TW weist an eine Stelle eine schmale Spalte SP als Unterbrechung der Trennwand TW auf, die zum Einführen eines in Figur nicht dargestellten Kabels in den ersten Gehäuseinnenraumteilbereich GT1 dient, der den Stromeingangsanschluss SE des Filterbauelements FE mit dem Energiespeicher ES elektrisch verbindet. Dabei ist die Spalte SP an einer Stelle der Trennwand TW angeordnet, welche bezogen auf einen Wandbereich der Trennwand TW den Bauelementen BE abgewandt liegt, sodass die elektromagnetischen Störfelder, die von den Bauelementen BE ausgestrahlt werden, von diesem Wandbereich der Trennwand TW absorbiert und somit gar nicht zu der Spalte SP gelangen können.

Zudem ist die Trennwand TW labyrinthartig geformt, wobei die Spalte SP den Eingang des Labyrinths bildet. Durch die labyrinthartigen Biegungen und Windungen der Trennwand TW und die Anordnung der Filterbauelemente FE hinter diesen Biegungen und Windungen der Trennwand TW werden die elektromagnetischen Störfelder von der Trennwand TW absorbiert und gedämpft, bevor diese zu den Filterbauelementen FE gelangen.

Analog weist die Abdeckplatte AP eine Aussparung in Form von einem dritten Durchgangsloch DL3 auf, das zum Einführen eines weiteren, in Figur nicht dargestellten Kabels in den ersten Gehäuseinnenraumteilbereich GT1 dient, der den Stromausgangsanschluss SA des Filterbauelements FE mit den Bauelementen BE der Brückenschaltung elektrisch verbindet.

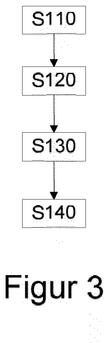

Ein Verfahren zur Herstellung des oben beschriebenen Stromrichters SR wird nachfolgend anhand eines in Figur 3 schematisch dargestellten Diagramms näher beschrieben.

Zur Herstellung des Stromrichters SR wird gemäß einem Verfahrensschritt S110 das Gehäuse GH in einem Spritzgießvorgang hergestellt, wobei beim Spritzgießen des Gehäuses GH die Trennwand TW an dem Gehäuse GH geformt wird.

Gemäß einem weiteren Verfahrensschritt S120 wird die Abdeckplatte AP auf das Filterbauelement FE platziert und mit dem Filterbauelement FE elektrisch leitend und mechanisch verbunden. Dabei werden die Masseanschlüsse MA des Filterbauelements FE mit den dafür vorgesehenen, vorab in Form von zweiten Durchgangslöchern DL2 ausgebildeten Verbindungsstellen an der Abdeckplatte AP in einem Lötvorgang verlötet.

Nachdem die Lötverbindungen zwischen dem Filterbauelement FE und der Abdeckplatte AP hergestellt wurden, wird die Abdeckplatte AP samt dem Filterbauelement FE gemäß einem anschließenden Verfahrensschritt S130 in den ersten Gehäuseinnenraumteilbereich ST1 angeordnet und an der Trennwand TW und dem Gehäuseabschnitt GW des Gehäuses GH befestigt. Dabei sind die Abdeckplatte AP, die Trennwand TW und der Gehäuseabschnitt GW im Vorfeld an entsprechenden Stellen vorab mit ersten Durchgangslöchern DL1 beziehungsweise mit Schraubenschächten SS versehen. Die Abdeckplatte AP wird dann mittels Schrauben SR an der Trennwand TW beziehungsweise dem Gehäuseabschnitt GW befestigt, wobei die Schrauben SR aus elektrisch leitendem Material bestehen und somit neben der mechanischen Verbindung noch niederohmige elektrische Verbindung von der Abdeckplatte AP beziehungsweise von dem Massenanschluss MA des Filterbauelements FE zu der Trennwand TW sowie dem Gehäuseabschnitt GW beziehungsweise zur elektrischen Masse herstellen.

Vorzugsweise werden die weiteren elektrischen oder elektronischen Bauelemente BE der Brückenschaltung im gleichen Befestigungsvorgang gemäß dem Verfahrensschritt S130 in den zweiten Gehäuseinnenraumteilbereich GT2 angeordnet und an dem Gehäuseboden GB beziehungsweise an der Gehäuseseitenwand GW in einer dem Fachmann bekannten Weise befestigt.

Anschließend wird der Gehäusedeckel gemäß einem nachfolgenden Verfahrensschritt S140 auf das Gehäuse GH luftdicht verschraubt.

## Patentansprüche

1. Schaltungsanordnung (SR), die folgende Merkmale aufweist:
- ein Gehäuse (GH), das folgende Merkmale aufweist:
• einen Gehäuseinnenraum (GI);
• eine für elektromagnetische Strahlung undurchlässige Trennwand (TW), die den Gehäuseinnenraum (GI) räumlich in einen ersten Gehäuseinnenraumteilbereich (GT1) und einen zweiten Gehäuseinnenraumteilbereich (GT2) teilt, wobei der erste Gehäuseinnenraumteilbereich (GT1) eingerichtet ist, ein erstes, als ein Filterbauelement ausgebildetes, elektrisches Bauelement (FE) aufzunehmen, und der zweite Gehäuseinnenraumteilbereich (GT2) eingerichtet ist, ein zweites, elektrisches Bauelement (BE) aufzunehmen;
• eine für elektromagnetische Strahlung undurchlässige Abdeckplatte (AP);
• einen für elektromagnetische Strahlung undurchlässigen Gehäuseabschnitt (GA), der direkt an dem ersten Gehäuseinnenraumteilbereich (GT1) angrenzt;
• wobei die Trennwand (TW), die Abdeckplatte (AP) und der Gehäuseabschnitt (GA) den ersten Gehäuseinnenraumteilbereich (GT1) dreidimensional umschließen, wodurch eine vollständige elektromagnetische Abschirmung des ersten Gehäuseinnenraumteilbereichs (GT1) gegenüber dem zweiten Gehäuseinnenraumteilbereich (GT2) vorgesehen wird;
- ein erstes, als ein Filterbauelement ausgebildetes elektrisches Bauelement (FE), angeordnet in dem ersten Gehäuseinnenraumteilbereich (GT1);
- ein zweites, elektrisches Bauelement (BE), angeordnet in dem zweiten Gehäuseinnenraumteilbereich (GT2);
- wobei das erste Bauelement (FE) einen Stromanschluss (MA) zur Herstellung einer elektrisch leitenden Verbindung mit einem elektrischen Massepotential aufweist und über diesen Stromanschluss (MA) mit der Abdeckplatte (AP), der Trennwand (TW) oder dem Gehäuseabschnitt (GA) direkt elektrisch leitend verbunden ist;
- wobei das erste Bauelement (FE) ferner an der Abdeckplatte (AP) über eine mechanische Verbindung befestigt ist, wobei diese mechanische Verbindung zugleich eine elektrische Verbindung ausbildet, die den Stromanschluss (MA) des ersten Bauelements (FE) mit der Abdeckplatte (AP) elektrisch leitend verbindet.

2. Schaltungsanordnung (SR) nach Anspruch 1, bei dem die Abdeckplatte (AP), die Trennwand (TW) und der Gehäuseabschnitt (GA) miteinander elektrisch leitend und mechanisch verbunden sind.

3. Schaltungsanordnung (SR) nach Anspruch 1 oder 2, bei dem die Trennwand (TW) und/oder der Gehäuseabschnitt (GA) mit einem elektrischen Stromanschluss (MA) des ersten Bauelements (FE) elektrisch leitend verbunden sind/ist.

4. Schaltungsanordnung (SR) nach Anspruch 1 oder 2, bei dem die Abdeckplatte (AP) direkt mit dem ersten Bauelement (FE) über den Stromanschluss (MA) elektrisch leitend und mechanisch verbunden ist.

5. Schaltungsanordnung (SR) nach einem der vorangehenden Ansprüche, bei dem die Trennwand(TW), die Abdeckplatte (AP) und/oder der Gehäuseabschnitt (GA) elektrisch leitendes und/oder weichmagnetisches Material umfassen.

6. Schaltungsanordnung (SR) nach Anspruch 5, bei dem die Trennwand (TW), die Abdeckplatte (AP) und/oder der Gehäuseabschnitt (GA) aus dem gleichen, elektrisch leitenden und/oder weichmagnetischen Material ausgebildet sind.

7. Schaltungsanordnung (SR) nach einem der vorangehenden Ansprüche, bei dem die Trennwand (TW) und der Gehäuseabschnitt (GA) einstückig ausgebildet sind.

8. Schaltungsanordnung (SR) nach einem der vorangehenden Ansprüche, wobei das erste Bauelement (FE) als ein Kondensator oder eine Spule ausgebildet ist.

9. Antriebsanordnung (AA) für ein Fahrzeug (FZ), die eine elektrische Maschine (EM) zum Antrieb des Fahrzeugs (FZ) aufweist, wobei die Antriebsanordnung (AA) ferner eine Schaltungsanordnung (SR) nach einem der vorangehenden Ansprüche aufweist, die über eine elektrische Verbindung (EV) mit der elektrischen Maschine (EM) verbunden ist und eingerichtet ist, für die elektrische Maschine (EM) elektrische Energie bereitzustellen.

10. Verfahren zur Herstellung einer Schaltungsanordnung (SR) nach einem der Ansprüche 1 bis 8, wobei das Verfahren folgende Verfahrensschritte aufweist:
- Herstellen einer elektrisch leitenden mechanischen Verbindung zwischen dem ersten elektrischen Bauelement (FE) und der Abdeckplatte (AP);
- Befestigen der Abdeckplatte (AP) mit der Trennwand (TW) und/oder dem Gehäuseabschnitt (GA), nachdem die elektrisch leitende mechanische Verbindung zwischen dem ersten Bauelement (FE) und der Abdeckplatte (AP) hergestellt wurde.

11. Verfahren nach Anspruch 10, wobei die elektrisch leitende mechanische Verbindung zwischen dem ersten elektrischen Bauelement (FE) und der Abdeckplatte (AP) mithilfe einer elektrisch leitenden mechanischen Verbindung zwischen dem Stromanschluss (MA) des ersten elektrischen Bauelements (FE) und der Abdeckplatte (AP) hergestellt wird, wobei der Stromanschluss (MA) zur Herstellung einer elektrisch leitenden Verbindung mit einem elektrischen Massepotential ausgebildet ist.

## Claims

1. Circuit arrangement (SR) which has the following features:
- a housing (GH) which has the following features:
• a housing interior (GI);
• a separating wall (TW) which is impermeable to electromagnetic radiation and which divides the housing interior (GI) spatially into a first housing interior subregion (GT1) and a second housing interior subregion (GT2), wherein the first housing interior subregion (GT1) is designed to accommodate a first electrical component (FE) in the form of a filter component, and the second housing interior subregion (GT2) is designed to accommodate a second electrical component (BE);
• a covering plate (AP) which is impermeable to electromagnetic radiation;
• a housing section (GA), which is impermeable to electromagnetic radiation and which directly adjoins the first housing interior subregion (GT1);
• wherein the separating wall (TW), the covering plate (AP) and the housing section (GA) surround the first housing interior subregion (GT1) three-dimensionally, as a result of which complete electromagnetic shielding of the first housing interior subregion (GT1) from the second housing interior subregion (GT2) is provided;
- a first electrical component (FE) in the form of a filter component, arranged in the first housing interior subregion (GT1);
- a second electrical component (BE), arranged in the second housing interior subregion (GT2);
- wherein the first component (FE) has an electrical terminal (MA) for producing an electrically conductive connection to an electrical ground potential and is electrically conductively connected directly via this electrical terminal (MA) to the covering plate (AP), the separating wall (TW) or the housing section (GA);
- wherein the first component (FE) is additionally fastened on the covering plate (AP) via a mechanical connection, wherein this mechanical connection at the same time forms an electrical connection, which electrically conductively connects the electrical terminal (MA) of the first component (FE) to the covering plate (AP).

2. Circuit arrangement (SR) according to Claim 1, in which the covering plate (AP), the separating wall (TW) and the housing section (GA) are electrically conductively and mechanically connected to one another.

3. Circuit arrangement (SR) according to Claim 1 or 2, in which the separating wall (TW) and/or the housing section (GA)are/is electrically conductively connected to an electrical terminal (MA) of the first component (FE).

4. Circuit arrangement (SR) according to Claim 1 or 2, in which the covering plate (AP) is electrically conductively and mechanically connected directly to the first component (FE) via the electrical terminal (MA).

5. Circuit arrangement (SR) according to one of the preceding claims, in which the separating wall (TW), the covering plate (AP) and/or the housing section (GA) comprise electrically conductive and/or soft-magnetic material.

6. Circuit arrangement (SR) according to Claim 5, in which the separating wall (TW), the covering plate (AP) and/or the housing section (GA) are formed from the same electrically conductive and/or soft-magnetic material.

7. Circuit arrangement (SR) according to one of the preceding claims, in which the separating wall (TW) and the housing section (GA) are formed integrally.

8. Circuit arrangement (SR) according to one of the preceding claims, wherein the first component (FE) is in the form of a capacitor or a coil.

9. Drive arrangement (AA) for a vehicle (FZ), which drive arrangement has an electric machine (EM) for driving the vehicle (FZ), wherein the drive arrangement (AA) additionally has a circuit arrangement (SR) according to one of the preceding claims, which circuit arrangement is connected to the electric machine (EM) via an electrical connection (EV) and is designed to provide electrical energy for the electric machine (EM).

10. Method for producing a circuit arrangement (SR) according to one of Claims 1 to 8, wherein the method has the following method steps:
- producing an electrically conductive mechanical connection between the first electrical component (FE) and the covering plate (AP);
- fastening the covering plate (AP) to the separating wall (TW) and/or the housing section (GA) once the electrically conductive mechanical connection between the first component (FE) and the covering plate (AP) has been produced.

11. Method according to Claim 10, wherein the electrically conductive mechanical connection between the first electrical component (FE) and the covering plate (AP) is produced with the aid of an electrically conductive mechanical connection between the electrical terminal (MA) of the first electrical component (FE) and the covering plate (AP), wherein the electrical terminal (MA) is designed to produce an electrically conductive connection to an electrical ground potential.

## Revendications

1. Circuit (SR) qui présente les caractéristiques suivantes :
- un boîtier (GH) présentant les caractéristiques suivantes :
• un espace intérieur de boîtier (GI) ;
• une cloison (TW) ne laissant pas passer de rayonnement électromagnétique et divisant spatialement l'espace intérieur de boîtier (GI) en une première partie d'espace intérieur de boîtier (GT1) et une seconde partie d'espace intérieur de boîtier (GT2), dans lequel la première partie d'espace intérieur de boîtier (GT1) est conçue pour loger un premier composant électrique (FE) réalisé sous la forme d'un composant de filtrage, et la seconde partie d'espace intérieur de boîtier (GT2) est conçue pour loger un second composant électrique (BE) ;
• une plaque de recouvrement (AP) ne laissant pas passer de rayonnement électromagnétique ;
• une section de boîtier (GA) ne laissant pas passer de rayonnement électromagnétique et directement adjacente à la première partie d'espace intérieur de boîtier (GT1) ;
• dans lequel la cloison (TW), la plaque de recouvrement (AP) et la section de boîtier (GA) entourent de manière tridimensionnelle la première section d'espace intérieur du boîtier (GT1), ce qui permet d'obtenir un blindage électromagnétique intégral de la première partie d'espace intérieur de boîtier (GT1) par rapport à la seconde partie d'espace intérieur de boîtier (GT2) ;
- un premier composant électrique (FE) réalisé sous la forme d'un composant de filtrage et disposé dans la première partie d'espace intérieur de boîtier (GT1) ;
- un second composant électrique (BE) disposé dans la seconde partie d'espace intérieur de boîtier (GT2) ;
- dans lequel le premier composant (FE) comporte une borne de courant (MA) pour établir une liaison électriquement conductrice avec un potentiel de masse électrique et est directement relié de manière électriquement conductrice à la plaque de recouvrement (AP), à la cloison (TW) ou à la section de boîtier (GA) par l'intermédiaire de ladite borne de courant (MA) ;
- dans lequel le premier composant (FE) est en outre fixé à la plaque de recouvrement (AP) par l'intermédiaire d'une liaison mécanique, dans lequel ladite liaison mécanique forme simultanément une liaison électrique qui relie de manière électriquement conductrice la borne de courant (MA) du premier composant (FE) à la plaque de recouvrement (AP).

2. Circuit (SR) selon la revendication 1, dans lequel la plaque de recouvrement (AP), la cloison (TW) et la section de boîtier (GA) sont reliées de manière électriquement conductrice et mécaniquement les unes aux autres.

3. Circuit (SR) selon la revendication 1 ou 2, dans lequel la cloison (TW) et/ou la section de boîtier (GA) sont reliées de manière électriquement conductrice à une borne de courant électrique (MA) du premier composant (FE) .

4. Circuit (SR) selon la revendication 1 ou 2, dans lequel la plaque de recouvrement (AP) est directement reliée de manière électriquement conductrice et mécaniquement au premier composant (FE) par l'intermédiaire de la borne de courant (MA).

5. Circuit (SR) selon l'une des revendications précédentes, dans lequel la cloison (TW), la plaque de recouvrement (AP) et/ou la section de boîtier (GA) comprennent un matériau électriquement conducteur et/ou magnétique doux.

6. Circuit (SR) selon la revendication 5, dans lequel la cloison (TW), la plaque de recouvrement (AP) et/ou la section de boîtier (GA) sont constituées du même matériau électriquement conducteur et/ou magnétique doux.

7. Circuit (SR) selon l'une des revendications précédentes, dans lequel la cloison (TW) et la section de boîtier (GA) sont réalisées en une seule pièce.

8. Circuit (SR) selon l'une des revendications précédentes, dans lequel le premier composant (FE) est réalisé sous la forme d'un condensateur ou d'une bobine.

9. Dispositif d'entraînement (AA) pour véhicule (FZ) comportant une machine électrique (EM) destinée à entraîner le véhicule (FZ), dans lequel le dispositif d'entraînement (AA) comprend en outre un circuit (SR) selon l'une des revendications précédentes, qui est relié à la machine électrique (EM) par l'intermédiaire d'une liaison électrique (EV) et est conçu pour fournir de l'énergie électrique destinée à la machine électrique (EM) .

10. Procédé de réalisation d'un circuit (SR) selon l'une des revendications 1 à 8, dans lequel le procédé comprend les étapes de procédé suivantes :
- établissement d'une liaison mécanique électriquement conductrice entre le premier composant électrique (FE) et la plaque de recouvrement (AP) ;
- fixation de la plaque de recouvrement (AP) à la cloison (TW) et/ou à la section de boîtier (GA) après que la liaison mécanique électriquement conductrice a été établie entre le premier composant (FE) et la plaque de recouvrement (AP).

11. Procédé selon la revendication 10, dans lequel la liaison mécanique électriquement conductrice entre le premier composant électrique (FE) et la plaque de recouvrement (AP) est établie au moyen d'une liaison mécanique électriquement conductrice entre la borne de courant (MA) du premier composant électrique (FE) et la plaque de recouvrement (AP), dans lequel la borne de courant (MA) est conçue pour établir une liaison électriquement conductrice avec un potentiel de masse électrique.
